# EUROPEAN PATENT SPECIFICATION

(11) **EP 4 007 465 B1**
(45) Date of publication and mention of the grant of the patent: **18.10.2023**
(21) Application number: 21199579.0
(22) Date of filing: 28.09.2021
(51) Int. Cl.: H05K 5/02, H05K 5/03

(54) **OPERATION PANEL FOR POWER CONVERSION DEVICE AND POWER CONVERSION DEVICE**
BEDIENUNGSTAFEL FÜR EINE LEISTUNGSUMWANDLUNGSVORRICHTUNG UND LEISTUNGSUMWANDLUNGSVORRICHTUNG
PANNEAU DE COMMANDE POUR DISPOSITIF DE CONVERSION DE PUISSANCE ET DISPOSITIF DE CONVERSION DE PUISSANCE

(30) Priority: 25.11.2020 JP 2020195170
(43) Date of publication of application: 01.06.2022
(73) Proprietor: Fuji Electric Co., Ltd., Kawasaki-shi, Kanagawa 210-9530 (JP)
(72) Inventor: YAMAZAWA, Kotaro, Kawasaki-shi, Kanagawa, 210-9530 (JP); URUMA, Tomoki, Kawasaki-shi, Kanagawa, 210-9530 (JP)
(74) Representative: Appelt, Christian W.

(56) References cited:
- JP-A- H11 233 090
- JP-A- 2014 170 151

## Description

### [Technical Field]

The present invention relates to an operation panel for a power conversion device and a power conversion device, and more particularly to an operation panel for a power conversion device and a power conversion device provided with an operation unit that operates a power conversion device main body portion.

### [Background Art]

In the related art, there is known an operation panel for a power conversion device provided with an operation unit (switch) that operates a power conversion device main body portion. Such an operation panel for a power conversion device is disclosed in, for example, Japanese Unexamined Patent Application, First Publication No. 2005-117733 (JP-A-2005-117733).

JP 2014-170151 A discloses an electronic device in which an SD card lid member provided in a main body casing is used to draw a SD card lid member provided in a main body casing to hold a slide position of the SD card lid member.

JP-A-2005-117733 discloses an operation panel for a power conversion device including a switch for selecting an operation method of a power conversion device main body portion, a switch for selecting an output frequency setting of the power conversion device main body portion, and a connector to connect to the power conversion device main body portion.

Functions required for the operation panel for a power conversion device have been increased in recent years. The functions required for the operation panel include enabling operation even when power supply from the power conversion device main body portion is shut down, in addition to enabling communication with an external device. Therefore, there is a demand for an operation panel in which a button battery is mounted as an auxiliary power source for the operation panel when the power supply is shut down and the button battery can be replaced.

However, in the operation panel for a power conversion device in the related art as described in JP-A-2005-117733, the operation panel is provided with an operation unit (switch) that operates the power conversion device main body portion. Therefore, when the button battery is mounted on the operation unit side in a replaceable manner as the auxiliary power source, a space on the operation unit side becomes narrow and thus it is impossible to provide a communication connector or the like for communicating with an external device on the operation unit side. Since a size of the operation panel main body is determined by the main body portion of the power conversion device to which the operation panel is connected, the size of the operation panel main body cannot be easily changed. Therefore, it is difficult to increase a printed circuit board to implement the communication connector or the like. As a result, there is a demand for an operation panel for a power conversion device and a power conversion device capable of suppressing the narrowing of the space on the operation unit side while mounting the button battery for supplying the power to the operation panel in a replaceable manner.

### [Summary of the Invention]

The present invention has been made to solve the above-mentioned problems, and one object of the present invention is to provide a demand for an operation panel for a power conversion device and a power conversion device capable of suppressing narrowing of a space on an operation unit side while mounting a button battery for supplying power to an operation panel in a replaceable manner.

The invention is defined by the features of claim 1. Further embodiments are defined in the dependent claims.

### [Brief Description of the Drawings]

[Fig. 1] Fig. 1 is a view of a state in which an operation panel according to an embodiment of the present invention is attached to a control panel.
[Fig. 2] Fig. 2 is a perspective view of a front side of the operation panel.
[Fig. 3] Fig. 3 is a perspective view of a rear side of the operation panel.
[Fig. 4] Fig. 4 is a disassembled perspective view seen from the rear side of the operation panel.
[Fig. 5A] Fig. 5A is a view of an operation panel board and is a view of a front surface of the operation panel board.
[Fig. 5B] Fig. 5B is a view of the operation panel board and is a view of a back surface of the operation panel board.
[Fig. 6] Fig. 6 is a rear view of the operation panel.
[Fig. 7] Fig. 7 is a view of a sealing member in a state where the operation panel is attached to the control panel.
[Fig. 8] Fig. 8 is a partial sectional view taken along a line 300-300 of Fig. 6.
[Fig. 9] Fig. 9 is the rear view of the operation panel in a state where a battery cover is detached.
[Fig. 10] Fig. 10 is a partial cross-sectional view taken along a line 400-400 of Fig. 9.
[Fig. 11] Fig. 11 is a perspective view for describing attachment of a button battery to the operation panel.
[Fig. 12] Fig. 12 is a view of a configuration of a snap-fit portion.
[Fig. 13] Fig. 13 is the rear view of the operation panel in a state where the button battery is detached.
[Fig. 14] Fig. 14 is a first view for describing disposition of a negative terminal.
[Fig. 15] Fig. 15 is a second view for describing the disposition of the negative terminal.
[Fig. 16] Fig. 16 is a view of a power conversion device according to a modification example.

### [Best Mode for Carrying Out the Invention]

Hereinafter, embodiments embodying the present invention will be described with reference to drawings.

### (Overall configuration of operation panel)

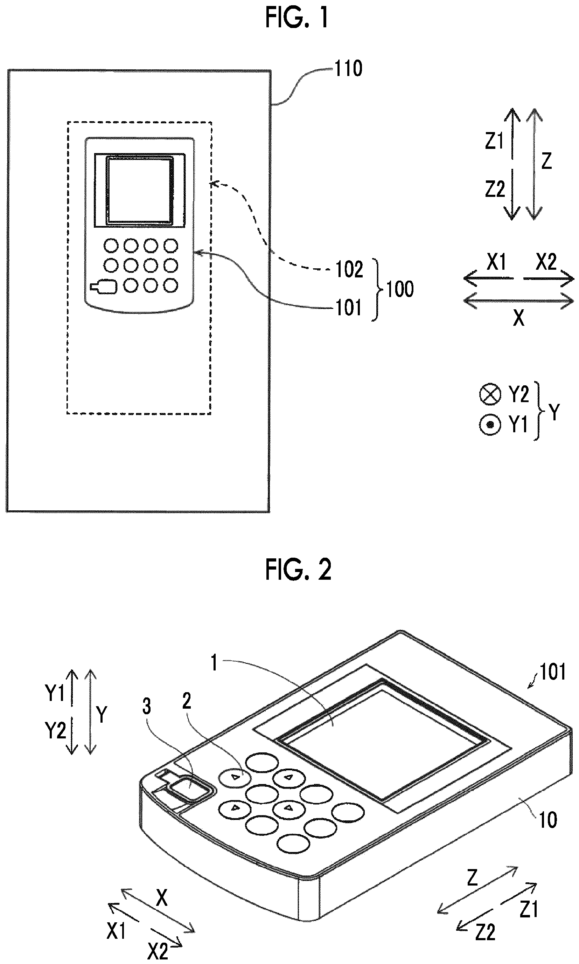

An overall configuration of a power conversion device 100 and an operation panel 101 according to one embodiment of the present invention will be described with reference to Fig. 1. The operation panel 101 is an example of an"operation panel for a power conversion device" in the claims.

The power conversion device 100 includes a power conversion device main body portion 102 and the operation panel 101 that receives an operation on the power conversion device main body portion 102.

The operation panel 101 is configured such that a rear side (Y2 direction side) of the operation panel 101 main body is attached to a control panel 110. The control panel 110 is configured to accommodate the power conversion device main body portion 102 and perform power control.

The control panel 110 is configured to control the power supplied to a load (not shown) outside the control panel 110. An electric device other than the power conversion device main body portion 102, such as a circuit breaker, an on/off switch, a switch (push button), a display, or an electric meter, may be accommodated inside the control panel 110.

The power conversion device 100 is, for example, an inverter device that converts AC power input from a commercial power source and outputs the converted power to the load. The power conversion device 100 is configured to communicate with an external device such as a personal computer (PC) .

The operation panel 101 is a device that operates a power conversion operation by the power conversion device 100 (power conversion device main body portion 102). The operation panel 101 is configured to be attached to and detached from the control panel 110 that accommodates the power conversion device main body portion 102. The operation panel 101 is attached detachably (to be attachable and detachable) to the power conversion device main body portion 102.

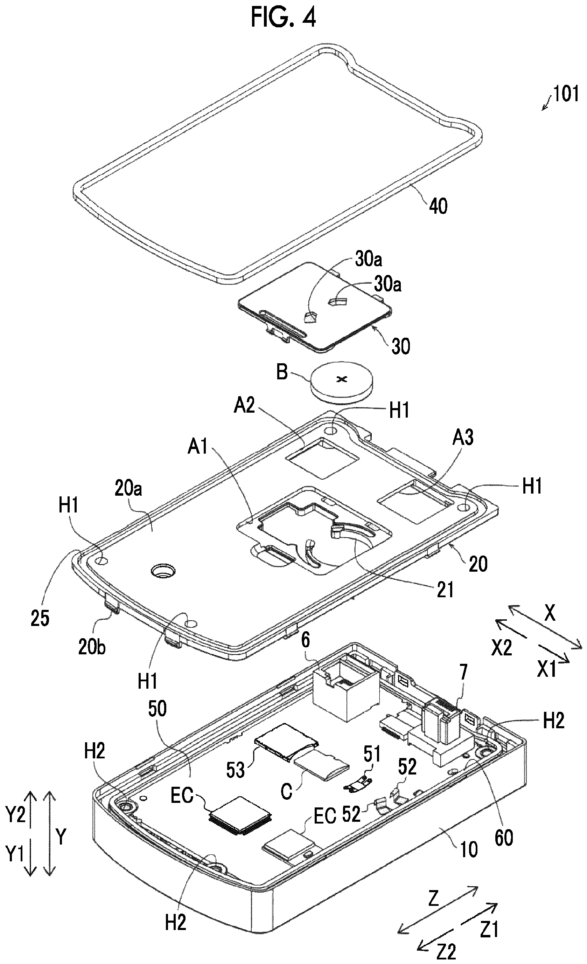

The operation panel 101 is configured such that the power is supplied from a button battery B (refer to Fig. 4) when the power supply is shut off, such as when the power conversion operation by the power conversion device main body portion 102 is stopped. Accordingly, the operation panel 101 is configured to maintain an operable state even when the power supply from the power conversion device main body portion 102 is shut off. That is, the operation panel 101 uses the button battery B as an auxiliary power source.

As shown in Fig. 2, the operation panel 101 includes a main body cover 10. A display 1, an operation button 2, and a terminal cover 3 are provided on a front side (Y1 direction side) of the operation panel 101.

The display 1 is a display device that checks a state, setting, or the like of the power conversion device 100 (power conversion device main body portion 102). The display 1 includes a liquid crystal display or an organic EL display.

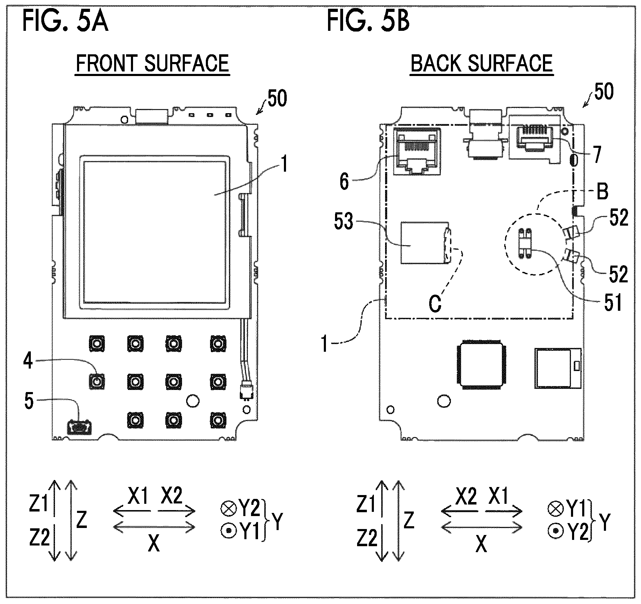

The operation button 2 is a button for operating the power conversion device main body portion 102 (power conversion device 100). The operation button 2 is provided on the front side (Y1 direction side) of an operation panel board 50 (refer to Fig. 5A) described below. The operation button 2 is a push button disposed so as to correspond to a plurality of switches 4 (refer to Fig. 5A) provided on the front side (Y1 direction side) of the operation panel board 50 described below. The operation button 2 and the switch 4 are examples of an "operation unit" in the claims.

The operation panel 101 is configured to receive an input operation based on the input operation by a user on a plurality of operation buttons 2. That is, the user can change the operation, setting, or the like of the power conversion device 100 (power conversion device main body portion 102) by operating the operation button 2.

The terminal cover 3 is provided so as to cover a connector 5 (refer to Fig. 5A) described below. The terminal cover 3 is configured detachably such that the connector 5 can be exposed when the connector 5 is used. The terminal cover 3 is configured to be elastically deformable. The terminal cover 3 is made of rubber, for example.

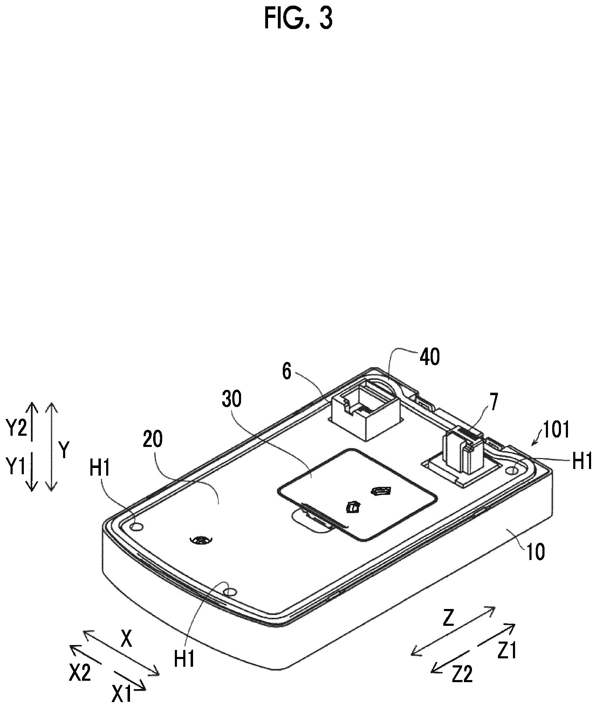

As shown in Fig. 3, the operation panel 101 includes a rear cover 20 and a battery cover 30. The rear cover 20 and the battery cover 30 are disposed on the rear side (Y2 direction side) of the operation panel 101.

As shown in Fig. 3, the operation panel 101 includes a sealing member 40 provided on the outside of the battery cover 30 so as to surround the battery cover 30. The sealing member 40 includes a waterproof packing. The sealing member 40 may include a potting material.

A hole portion for fastening H1 is provided on the rear side (Y2 direction side) of the operation panel 101, as shown in Fig. 3. The hole portion for fastening H1 is provided on the rear cover 20 and is a hole portion used when the operation panel 101 is fastened and fixed to the control panel 110.

On the rear side (Y2 direction side) of the operation panel 101, connectors 6 and 7 for communicably connecting the power conversion device main body portion 102 and the operation panel 101 (operation panel board 50) are provided, as shown in Fig. 3.

Each of the connectors 6 and 7 is provided so as to project from a back surface (surface on Y2 direction side) of the operation panel board 50 (refer to Fig. 4) toward the outside (Y2 direction side) of the operation panel 101.

As shown in Fig. 4, the operation panel 101 includes the operation panel board 50. The operation panel board 50 is a printed circuit board (PCB) in which a wiring pattern is formed by a conductor and electronic components EC such as a central processing unit (CPU) and a read only memory (ROM) or a random access memory (RAM) are mounted.

The operation panel 101 includes a negative terminal 51 and a positive terminal 52, which correspond to the button battery B for supplying the power to the operation panel board 50, provided on the back surface (surface on Y2 direction side) of the operation panel board 50. The negative terminal 51 is an example of a "first terminal" in the claims, and the positive terminal 52 is an example of a "second terminal" in the claims.

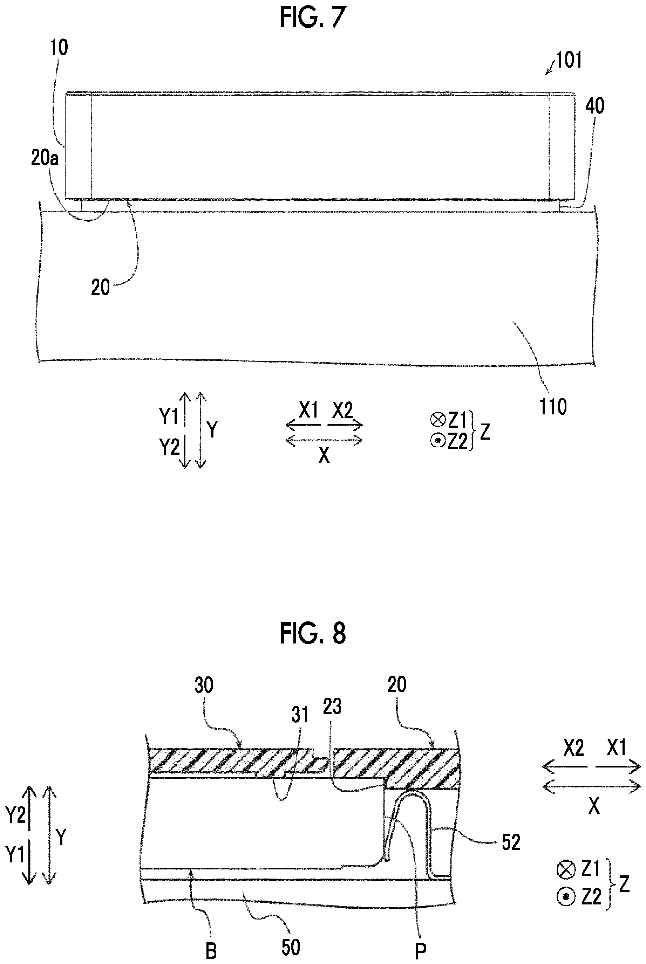

The negative terminal 51 is provided on the back surface (surface on Y2 direction side) of the operation panel board 50 so as to be pressed from the Y2 direction side by a negative pole on a lower surface of the button battery B. The negative terminal 51 is configured to be flexurally deformable in the Y1 direction side. The positive terminal 52 is provided on the back surface (surface on Y2 direction side) of the operation panel board 50 so as to be pressed from an X2 direction side by a positive pole of an outer peripheral surface P (refer to Fig. 8) of the button battery B.

The button battery B is a battery having a button shape (coin shape). The button battery B may be a primary battery or a secondary battery. The button battery B may be a battery containing lithium or a battery containing an alkaline material.

The operation panel 101 is provided on the back surface (surface on Y2 direction side) of the operation panel board 50 and includes a card slot portion 53 for inserting a memory card C, as shown in Fig. 4. The operation panel 101 (operation panel board 50) is configured such that data can be written (saved) to the inserted memory card C using the card slot portion 53 and such that the data stored (saved) in the inserted memory card C can be read.

The memory card C is a storage device having a card shape including a flash memory and the like. For example, the memory card C is an SD memory card, a USB memory card, or a memory stick. The memory card C stores data such as a communication log or a communication setting with a device outside the power conversion device 100 (power conversion device main body portion 102).

The operation panel board 50 is accommodated inside the main body cover 10. A sealing member 60 (refer to Fig. 4) is provided so as to surround the operation panel board 50. The sealing member 60 includes a waterproof packing. The sealing member 60 may be a member (sealing member) containing the same material as the sealing member 40 or may be a member containing a different material. The main body cover 10 is provided with a hole portion for fastening H2 (refer to Fig. 4) that communicates with the hole portion for fastening H1 of the rear cover 20.

The rear cover 20 has a groove portion 25 that is formed along near an outer peripheral portion of a surface 20a of the rear cover 20 facing the control panel 110 and into which the sealing member 40 is fitted (refer to Fig. 4). The sealing member 40 adheres to the groove portion 25 with a double-sided tape or the like.

The rear cover 20 is provided with a snap-fit portion 21 (refer to Fig. 4) for positioning the button battery B with respect to the negative terminal 51 and the positive terminal 52 and an opening portion A1 provided so as to expose the snap-fit portion 21 (refer to Fig. 4). The snap-fit portion 21 is an example of a "battery positioning portion" in the claims. In the present embodiment, the snap-fit portion 21 can position the button battery B with respect to the negative terminal 51 and the positive terminal 52. Therefore, when the button battery B is attached, the button battery B can be reliably contacted with the negative terminal 51 and the positive terminal 52.

The rear cover 20 is provided with an opening portion A2 for exposing the connector 6 and an opening portion A3 for exposing the connector 7.

The rear cover 20 is disposed so as to cover the back surface of the operation panel board 50. The rear cover 20 has a snap-fit portion 20b (refer to Fig. 4) that projects toward the main body cover 10 (operation panel board 50) side (Y1 direction side). The rear cover 20 is configured to be fitted and fixed to the main body cover 10 by the snap-fit portion 20b. With the sealing member 60 provided so as to surround the operation panel board 50, it is possible to prevent water from intruding between the rear cover 20 and the main body cover 10 (gap).

The battery cover 30 is configured to be attached to and detached from the rear cover 20. The battery cover 30 is provided with a hole portion 30a (refer to Fig. 4).

The main body cover 10, the rear cover 20, and the battery cover 30 are made of members containing resin. The main body cover 10, the rear cover 20, and the battery cover 30 are formed of, for example, ABS resin.

As shown in Fig. 5A, the display 1, the switch 4, and the connector 5 are provided (implemented) on the front side (Y1 direction side) of the operation panel board 50. The plurality of switches 4 are provided corresponding to the plurality of operation buttons 2. The connector 5 is provided for communicably connecting to the device outside the power conversion device 100 (control panel 110) such as a personal computer (PC). For example, the connector 5 is a USB terminal that is communicably connected to the device outside the power conversion device 100 (control panel 110) such as the PC. The display 1, the switch 4, and the connector 5 are electrically connected to the wiring pattern formed on the operation panel board 50.

As shown in Fig. 5B, the connector 6, the connector 7, the negative terminal 51, the positive terminal 52, and the card slot portion 53 are provided (implemented) on a back side (Y2 direction side) of the operation panel board 50. The positive terminal 52, the negative terminal 51, and the card slot portion 53 are disposed in this order from an X1 direction side, viewed from the back side (Y2 direction side) of the operation panel board 50. The negative terminal 51, the positive terminal 52, and the card slot portion 53 are electrically connected to the wiring pattern formed on the operation panel board 50.

The negative terminal 51, the positive terminal 52, and the card slot portion 53 are provided near a central portion on the back side (Y2 direction side) of the operation panel board 50 in a Z direction. The negative terminal 51, the positive terminal 52, and the card slot portion 53 are disposed at a position overlapping the display 1 provided on the front side (Y1 direction side) of the operation panel board 50, viewed from a Y direction (Y1 direction side or Y2 direction side) (refer to Figs. 5A and 5B).

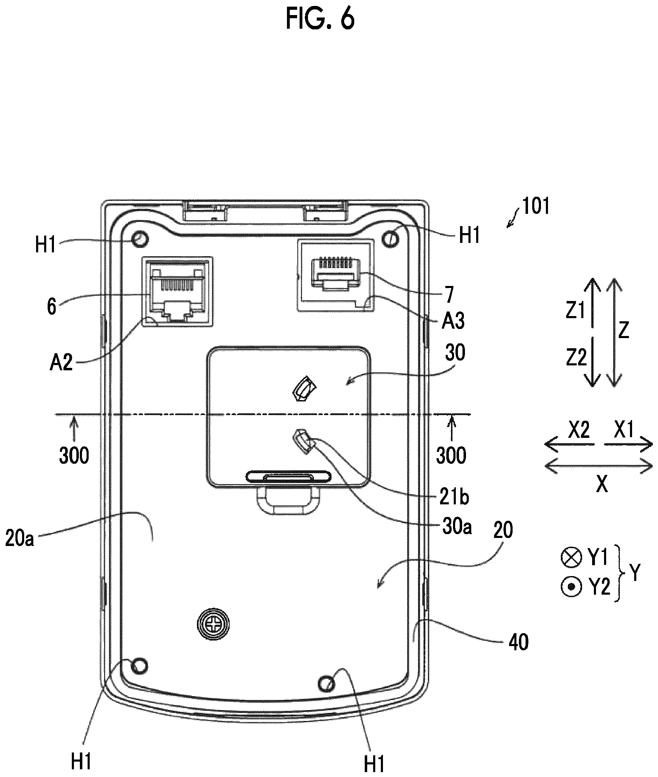

As shown in Fig. 6, the battery cover 30 is disposed near a central portion of the surface 20a of the rear cover 20 facing the control panel 110.

The battery cover 30 is provided so as to cover the opening portion A1 (refer to Fig. 4). In a state where the battery cover 30 is attached, a claw portion 21b of the snap-fit portion 21 described below is configured to be exposed from the hole portion 30a of the battery cover 30, as shown in Fig. 6.

The sealing member 40 is disposed so as to surround the connector 6 (opening portion A2), the connector 7 (opening portion A3), and the hole portion for fastening H1, as shown in Fig. 6. That is, the operation panel 101 is attached to the control panel 110 on the surface 20a of the rear cover 20 facing the control panel 110, using the hole portion for fastening H1 provided inside the sealing member 40.

As shown in Fig. 7, the sealing member 40 is disposed between the rear cover 20 and the control panel 110 when the rear side (Y2 direction side) of the operation panel 101 is attached to the control panel 110. The sealing member 40 is configured such that the main body of the operation panel 101 (rear cover 20) is attached to the control panel 110 and is pressed against the control panel 110 to be elastically deformed.

As shown in Fig. 8, the positive terminal 52 is disposed on the outer peripheral surface P side of the button battery B and is configured to be flexurally deformable. The rear cover 20 includes a position regulating portion 23 that regulates a position of the outer peripheral surface P of the button battery B with respect to the positive terminal 52 in order to regulate a flexural deformation amount of the positive terminal 52, as shown in Fig. 8. The position regulating portion 23 is a step provided on the rear cover 20, and the button battery B is caught by the position regulating portion 23 (step) to regulate movement of the button battery B in the X1 direction side.

The battery cover 30 includes a projection portion 31 that projects toward the negative terminal 51 side (Y1 direction side) provided on the operation panel board 50 in a state of being attached to the rear cover 20 to press the button battery B toward the negative terminal 51 side (refer to Fig. 8). A tip end of the projection portion 31 (end portion on Y1 direction side) is formed flat and presses the button battery B from the Y2 direction side in the state where the battery cover 30 is attached.

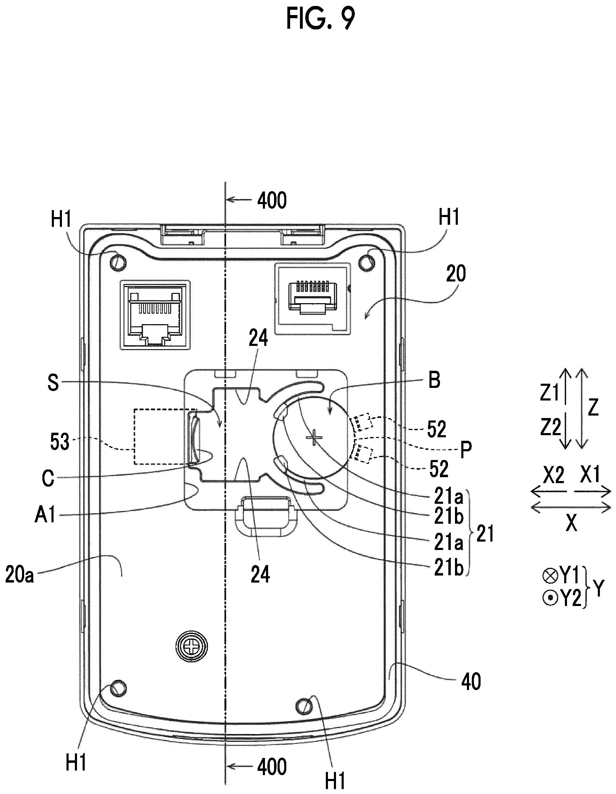

As shown in Fig. 9, the operation panel board 50 is provided with a stroke area S for sliding the memory card C to insert the card into the card slot portion 53 and remove the card from the card slot portion 53.

As shown in Fig. 9, the positive terminal 52 is disposed on the outside (X1 direction side) of the opening portion A1 provided on the surface 20a of the rear cover 20, viewed from the Y2 direction side. As shown in Fig. 9, in a state where the button battery B is attached, a part of the positive terminal 52 side (X1 direction side) of the button battery B is disposed on the outside (X1 direction side) of the opening portion A1 provided on the surface 20a of the rear cover 20, viewed from the Y2 direction side. That is, the positive terminal 52 and the part of the positive terminal 52 side of the button battery B are covered with the rear cover 20 on the Y2 direction side.

As shown in Fig. 9, the stroke area S is provided between the card slot portion 53 and the snap-fit portion 21. The stroke area S is an area for sliding and moving the memory card C and is an area where a component constituting an electronic circuit, such as the electronic component EC, is not attached (not implemented) on the back surface (surface on Y2 direction side) of the operation panel board 50.

Accordingly, the user can insert the memory card C into the card slot portion 53 by sliding and moving the memory card C from the stroke area S to the card slot portion 53 side (X2 direction side). The user can remove the memory card C from the card slot portion 53 by sliding and moving the memory card C from the card slot portion 53 to the stroke area S side (X1 direction side).

In the present embodiment, a plurality (two) of positive terminals 52 are provided along the outer peripheral surface P of the button battery B, as shown in Fig. 9. The plurality of positive terminals 52 are electrically connected by a conductor pattern formed on the operation panel board 50.

As shown in Fig. 9, the snap-fit portion 21 is provided along the outer peripheral surface P of the button battery B and is configured to be flexurally deformable at the time of the attachment and detachment of the button battery B.

As shown in Fig. 9, the snap-fit portion 21 includes a pair of arm portions having an arc shape 21a, which are elastically deformable, provided in an arc shape along the outer peripheral surface P of the button battery B.

As shown in Fig. 9, in the snap-fit portion 21, tip ends of the pair of arm portions having the arc shape 21a are provided on the side where the stroke area S is disposed with respect to the button battery B (X2 direction side).

As shown in Fig. 9, the snap-fit portion 21 includes claw portions 21b provided near tip end portions of the pair of arm portions having the arc shape 21a. The claw portion 21b is configured to cover (press) a part of the button battery B from the Y2 direction side in a state where the button battery B is attached to an area surrounded by the pair of arm portions having the arc shape 21a.

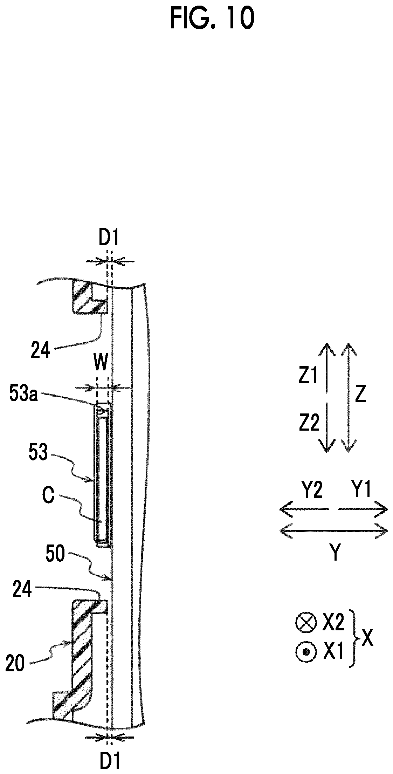

As shown in Fig. 10, the rear cover 20 includes an intrusion prevention portion 24 that prevents the memory card C from intruding between the rear cover 20 and the operation panel board 50 by projecting toward the operation panel board 50 side (Y1 direction side). The intrusion prevention portion 24 is provided along an outer edge of the stroke area S, as shown in Fig. 9.

A distance D1, in the Y direction, between the intrusion prevention portion 24 and the operation panel board 50 (refer to Fig. 10) is smaller than a width W, in the Y direction, of an insertion port 53a of the card slot portion 53 into which the memory card C is inserted (refer to Fig. 10). The distance D1, in the Y direction, between the intrusion prevention portion 24 and the operation panel board 50 (refer to Fig. 10) is a size such that the memory card C does not enter between the rear cover 20 and the operation panel board 50.

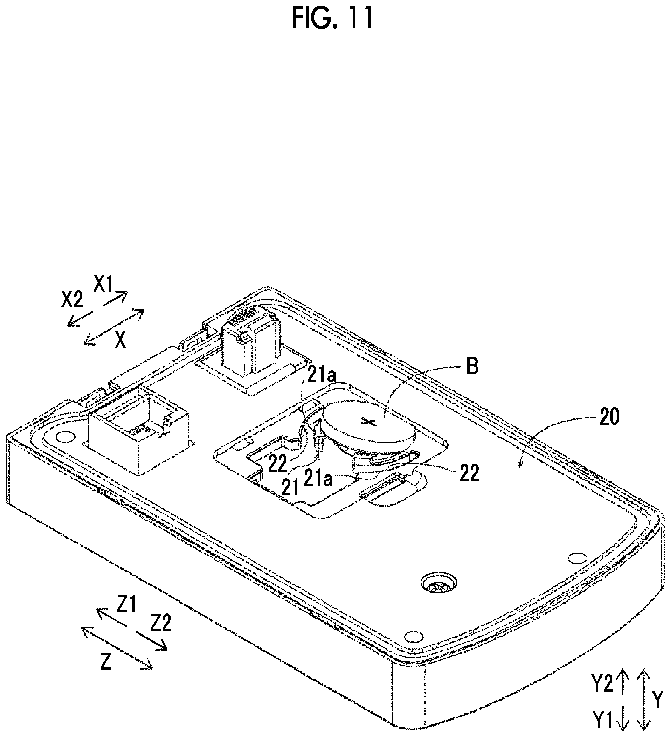

At the time of the attachment of the button battery B, the user attaches the button battery B by pressing and expanding (flexurally deforming) the pair of arm portions having the arc shape 21a of the snap-fit portion 21, in a state where the button battery B is tilted to the X direction along a surface of the back side of the operation panel board 50 (in a slanted state), as shown in Fig. 11.

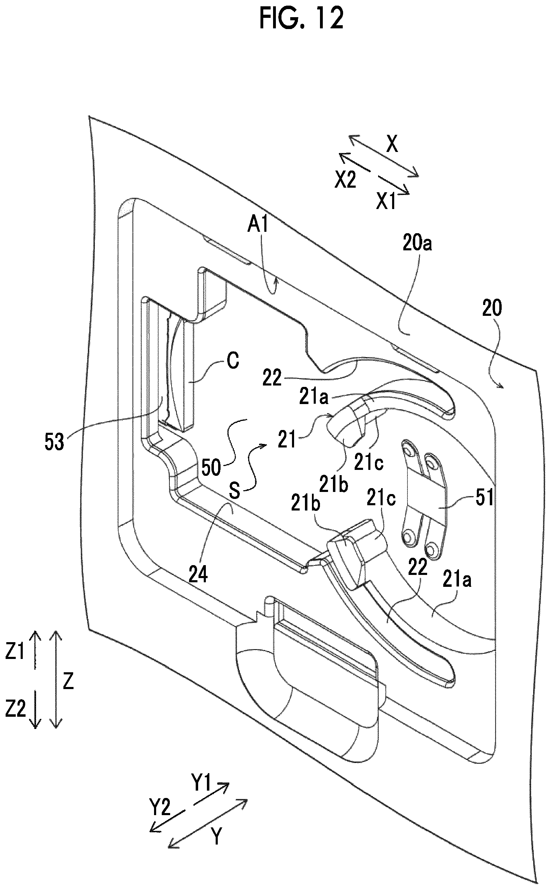

The rear cover 20 includes a flexure regulating portion 22 that regulates the flexural deformation amount of the snap-fit portion 21 at the time of the attachment and detachment of the button battery B, as shown in Figs. 11 and 12. The flexure regulating portion 22 is a wall having an arc shape formed (disposed) along the pair of arm portions having the arc shape 21a of the snap-fit portion 21.

The snap-fit portion 21 is provided with a positioning projection portion 21c for positioning a position of the button battery B with respect to the positive terminal 52, as shown in Fig. 12. The positioning projection portion 21c projects to the side where the button battery B is disposed and to the side where the positive terminal 52 is disposed.

Specifically, the positioning projection portion 21c is provided inside each of the pair of arm portions having the arc shape 21a. That is, one positioning projection portion 21c is provided for one arm portion 21a. The positioning projection portion 21c is configured to project in an arc shape from the inside of each of the pair of arm portions having the arc shape 21a toward the button battery B side (negative terminal 51 side). The positioning projection portion 21c is provided on the operation panel board 50 side (Y1 direction side) with respect to the claw portion 21b. The arm portion 21a, the positioning projection portion 21c, the flexure regulating portion 22, and the intrusion prevention portion 24 are continuously (integrally) formed, as shown in Fig. 12.

The opening portion A1 is provided on the rear cover 20 such that the snap-fit portion 21 and the stroke area S are exposed, as shown in Fig. 12. The opening portion A1 is provided on the rear cover 20 such that the flexure regulating portion 22 and the negative terminal 51 are exposed. The opening portion A1 is formed in a stepped shape such that the operation panel board 50 is exposed along outer edges of the arm portion 21a, the positioning projection portion 21c, the flexure regulating portion 22, and the intrusion prevention portion 24.

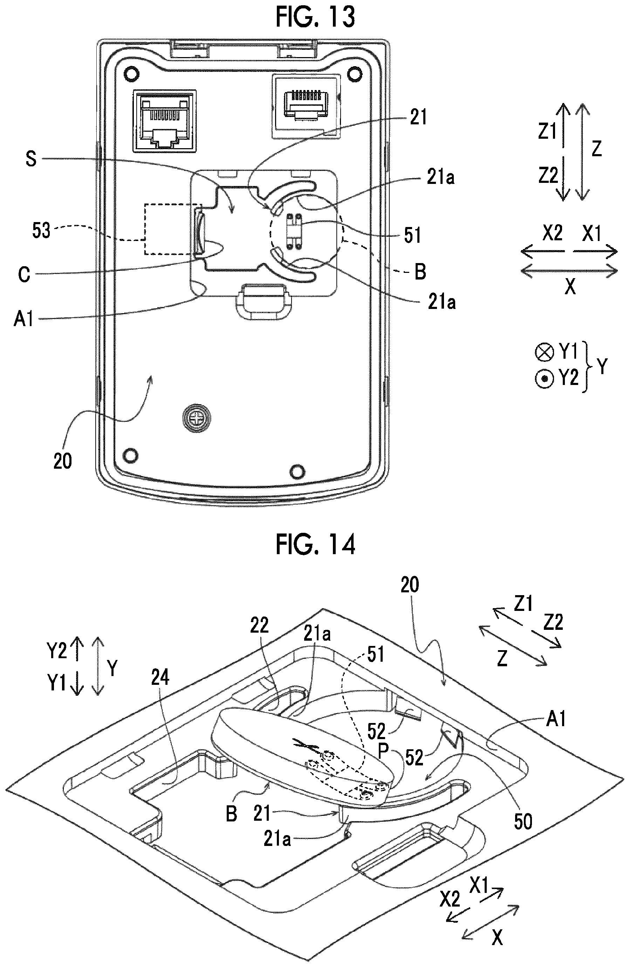

As shown in Fig. 13, the negative terminal 51 is disposed on the tip end side of the pair of arm portions having the arc shape 21a (X2 direction side) from a central portion of the position where the button battery B is disposed, in the area surrounded by the pair of arm portions having the arc shape 21a.

As shown in Fig. 14, the rear cover 20 covers the Y2 direction side of the positive terminal 52. Therefore, the user inserts (attaches) the button battery B into the area surrounded by the pair of arm portions having the arc shape 21a, in the state where the button battery B is tilted to the X direction along the surface of the back side of the operation panel board 50 (in the slanted state) such that the outer peripheral surface P on the X1 direction side faces the Y1 direction side.

Therefore, the negative terminal 51 is disposed at a position where the positive and negative poles of the button battery B are not short-circuited even in a case where the button battery B is inserted in a tilted state (inserted slantingly) into the area surrounded by the pair of arm portions having the arc shape 21a.

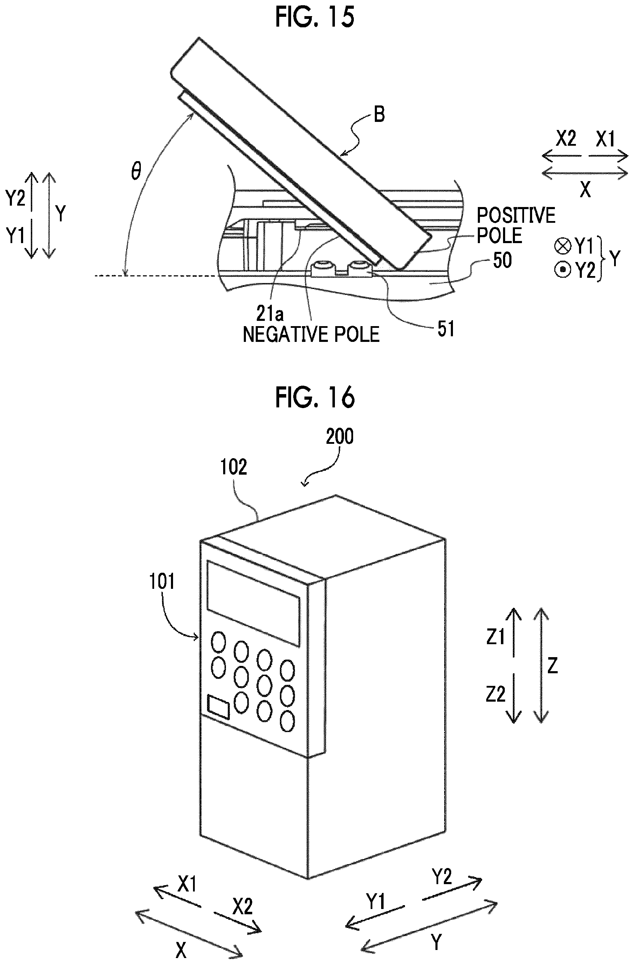

Specifically, with the interference of the pair of arm portions having the arc shape 21a with the button battery B, the negative terminal 51 is disposed at a position shifted toward the X2 direction side from the central portion of the position where the button battery B is disposed, up to a position where a tilt angle of the button battery B with respect to the negative terminal 51 can be increased to an angle θ where both the positive and negative poles of the button battery B do not contact the negative terminal 51 at the same time (refer to Fig. 15).

### (Effect of present embodiment)

In the present embodiment, the following effects can be obtained.

In the present embodiment, the operation button 2 (switch 4) for operating the power conversion device main body portion 102 is provided on the front side (Y1 direction side) of the operation panel board 50. The negative terminal 51 and the positive terminal 52 are provided, corresponding to the button battery B, on the back surface (surface on Y2 direction side) of the operation panel board 50. Accordingly, the button battery B can be mounted on the back surface (surface on Y2 direction side) of the operation panel board 50 provided with the negative terminal 51 and the positive terminal 52. Therefore, it is possible to suppress narrowing of a space on the operation button 2 (switch 4) side of the operation panel 101, unlike the case where the button battery B is mounted on the front side (Y1 direction side) of the operation panel board 50 provided with the operation button 2 (switch 4). The battery cover 30 configured to be attached to and detached from the rear cover 20 covers the opening portion A1 provided such that the snap-fit portion 21 is exposed. Therefore, the user can attach and detach the button battery B (replace button battery B) with respect to the snap-fit portion 21 that positions the button battery B by detaching the battery cover 30. As a result, it is possible to provide the operation panel 101 and the power conversion device 100 capable of suppressing the narrowing of the space on the operation button 2 (switch 4) side of the operation panel 101 while mounting the button battery B for supplying the power to the operation panel 101 in a replaceable manner.

In the present embodiment, the operation panel 101 main body is detachably attached to the power conversion device main body portion 102, as described above. Accordingly, it is possible to easily attach and detach the button battery B (replace button battery B) with respect to the negative terminal 51 and the positive terminal 52 provided on the back surface (surface on Y2 direction side) of the operation panel board 50.

In the present embodiment, the card slot portion 53 for inserting the memory card C is provided on the back surface (surface on Y2 direction side) of the operation panel board 50. Therefore, it is possible to store the communication setting, the communication log, or the like with the device outside the power conversion device 100 in the memory card C by mounting the memory card C on the back surface of the operation panel board 50, as described above. The operation panel board 50 is provided with the stroke area S for sliding the memory card C to insert the card into the card slot portion 53 and remove the card from the card slot portion 53. Therefore, it is possible to easily insert the memory card C into the card slot portion 53 and remove the memory card C from the card slot portion 53. Further, the opening portion A1 is provided, on the rear cover 20, such that the snap-fit portion 21 and the stroke area S are exposed. Therefore, it is possible to provide the battery cover 30 provided so as to cover the opening portion A1 in common with respect to the snap-fit portion 21 and the stroke area S. As a result, it is possible to suppress an increase in the number of components and a complicated device configuration.

In the present embodiment, the stroke area S is provided between the card slot portion 53 and the snap-fit portion 21, as described above. Accordingly, it is possible to put the snap-fit portion 21 and the stroke area S close to each other, unlike the case where the stroke area S is provided on the side (X2 direction side) opposite to the side where the snap-fit portion 21 is disposed with respect to the card slot portion 53. Therefore, it is possible to reduce the opening portion A1 where the snap-fit portion 21 and the stroke area S are exposed. As a result, when the user detaches the battery cover 30 provided so as to cover the opening portion A1 and performs the work, it is possible to suppress intrusion of foreign matter into the operation panel 101.

In the present embodiment, the snap-fit portion 21 is configured to be flexurally deformable at the time of the attachment and detachment of the button battery B, and the rear cover 20 includes the flexure regulating portion 22 that regulates the flexural deformation amount of the snap-fit portion 21 at the time of the attachment and detachment of the button battery B, as described above. Accordingly, since the flexure regulating portion 22 can regulate the flexural deformation amount of the snap-fit portion 21, it is possible to suppress damage of the snap-fit portion 21 due to excessive flexure of the snap-fit portion 21 at the time of the attachment and detachment of the button battery B (replacement of button battery B).

In the present embodiment, the snap-fit portion 21 is provided along the outer peripheral surface P of the button battery B and is configured to be flexurally deformable at the time of the attachment and detachment of the button battery B, as described above. Accordingly, since the snap-fit portion 21 can be flexurally deformed at the time of the attachment and detachment of the button battery B, it is possible to easily attach and detach the button battery B (replace button battery B). The snap-fit portion 21 provided along the outer peripheral surface P of the button battery B is provided with the positioning projection portion 21c that projects on the side where the button battery B is disposed and on the side where the positive terminal 52 is disposed. Therefore, it is possible to press the button battery B attached to the snap-fit portion 21 toward the positive terminal 52 side. As a result, it is possible to reliably bring the button battery B and the positive terminal 52 into contact with each other at the time of the attachment of the button battery B.

In the present embodiment, the snap-fit portion 21 includes the pair of arm portions having the arc shape 21a, which are elastically deformable, provided in the arc shape along the outer peripheral surface P of the button battery B, and the tip ends of the pair of arm portions having the arc shape 21a are provided on the side where the stroke area S is disposed with respect to the button battery B (X2 direction side), as described above. Accordingly, the user can easily press and expand the pair of arm portions having the arc shape 21a, which are elastically deformable, of the snap-fit portion 21 from the stroke area S side at the time of the detachment of the button battery B. As a result, it is possible to easily detach the button battery B.

In the present embodiment, the negative terminal 51 is disposed on the tip end side of the pair of arm portions having the arc shape 21a from the central portion of the position where the button battery B is disposed, in the area surrounded by the pair of arm portions having the arc shape 21a, as described above. Accordingly, with the disposition of the negative terminal 51 on the tip end side of the pair of arm portions having the arc shape 21a from the central portion of the position where the button battery B is disposed, it is possible to dispose the negative terminal 51 at a position separated from the positive pole provided on the outer peripheral surface P of the button battery B, compared with a case where the negative terminal 51 is disposed at the central portion of the position where the button battery B is disposed. As a result, it is possible to prevent the positive and negative poles of the button battery B from being short-circuited due to the contact of both the positive and negative poles of the button battery B with the negative terminal 51 at the time of the attachment and detachment of the button battery B (replacement of the button battery B) .

In the present embodiment, the positive terminal 52 is disposed on the outer peripheral surface P side of the button battery B and is configured to be flexurally deformable, as described above. The rear cover 20 includes the position regulating portion 23 that regulates the position of the outer peripheral surface P of the button battery B with respect to the positive terminal 52 to regulate the flexural deformation amount of the positive terminal 52. Accordingly, with the position regulating portion 23 that regulates the position of the outer peripheral surface P of the button battery B with respect to the positive terminal 52, it is possible to regulate the flexural deformation amount of the positive terminal 52 at the time of the attachment and detachment of the button battery B (replacement of the button battery B). As a result, it is possible to prevent the positive terminal 52 from being damaged due to excessive flexure of the positive terminal 52 at the time of the attachment and detachment of the button battery B (replacement of the button battery B).

In the present embodiment, the plurality (two) of positive terminals 52 are provided along the outer peripheral surface P of the button battery B, as described above. Accordingly, since the plurality (two) of positive terminals 52 are provided along the outer peripheral surface P of the button battery B, it is possible to bring any positive terminal 52 into contact with the button battery B even in a case where the attachment position of the button battery B is displaced on the operation panel board 50, unlike a case where only one positive terminal 52 is provided. As a result, it is possible to reliably bring the button battery B and the positive terminal 52 into contact with each other, as compared with a case where only one positive terminal 52 is provided.

In the present embodiment, the rear cover 20 is provided along the outer edge of the stroke area S so as to project toward the operation panel board 50 side (Y1 direction side), and includes the intrusion prevention portion 24 that prevents the memory card C from intruding between the rear cover 20 and the operation panel board 50, as described above. Accordingly, it is possible to prevent the memory card C from intruding between the rear cover 20 and the operation panel board 50 when the memory card C is inserted into and removed from the card slot portion 53 in the stroke area S. As a result, it is possible to improve workability when the memory card C, which stores the communication setting, the communication log, or the like with the device outside the power conversion device 100, is inserted into and removed from the card slot portion 53.

In the present embodiment, the battery cover 30 includes the projection portion 31 that projects toward the negative terminal 51 side (Y1 direction side) provided on the operation panel board 50 in the state of being attached to the rear cover 20 to press the button battery B toward the negative terminal 51 side, as described above. Accordingly, since the button battery B is pressed toward the negative terminal 51 side (Y1 direction side) by the projection portion 31 of the battery cover 30, it is possible to reliably bring the button battery B and the negative terminal 51 into contact with each other at the time of the attachment of the button battery B.

In the present embodiment, the power conversion device main body portion 102 is accommodated, and the rear side (Y2 direction side) of the operation panel 101 main body is configured to be attached to the control panel 110 that performs the power control, as described above. The sealing member 40 provided on the outside of the battery cover 30 so as to surround the battery cover 30 is provided between the rear cover 20 and the control panel 110. Accordingly, with the sealing member 40, between the rear cover 20 and the control panel 110, provided on the outside of the battery cover 30 so as to surround the battery cover 30, it is possible to prevent water from intruding between the rear cover 20 and the control panel 110 in a state where the rear side (Y2 direction side) of the operation panel 101 main body is attached to the control panel 110. As a result, it is possible to prevent water from intruding between the rear cover 20 and the battery cover 30 in the state where the rear side (Y2 direction side) of the operation panel 101 main body is attached to the control panel 110.

In the present embodiment, the battery cover 30 is disposed near the central portion of the surface 20a of the rear cover 20 facing the control panel 110, as described above. The rear cover 20 has the groove portion 25 that is formed along near an outer peripheral portion of a surface 20a of the rear cover 20 facing the control panel 110 and into which the sealing member 40 is fitted. Accordingly, since the sealing member 40 is disposed along near the outer peripheral portion of the surface 20a of the rear cover 20 facing the control panel 110, it is possible to make an area where water can be prevented from intruding between the rear cover 20 and the control panel 110 relatively large on the surface 20a of the rear cover 20 facing the control panel 110. With the disposition of the battery cover 30 near the central portion of the surface 20a of the rear cover 20 facing the control panel 110, it is possible to easily surround the battery cover 30 with the sealing member 40, as compared with a case where the battery cover 30 is provided near the outer peripheral portion of the surface 20a of the rear cover 20 facing the control panel 110. As a result, it is possible to easily prevent water from intruding between the rear cover 20 and the battery cover 30.

## Claims

1. An operation panel (101) for a power conversion device (100) comprising:
an operation panel board (50) provided with operation units (2, 4) that operate a power conversion device main body portion (102) on a front side;
a first terminal (51) and a second terminal (52) provided corresponding to a button battery (B) for supplying power to the operation panel board on a back surface of the operation panel board;
a rear cover (20) including a battery positioning portion (21) configured to position the button battery with respect to the first terminal and the second terminal and an opening portion (A1) provided such that the battery positioning portion is exposed, which is disposed so as to cover the back surface of the operation panel board;
a battery cover (30) which is configured to be attached to and detached from the rear cover and provided so as to cover the opening portion and
a card slot portion (53) for inserting a memory card (C), which is provided on the back surface of the operation panel board,
wherein the operation panel is structured such that the memory card (C) can be removed from the card slot portion (53) by sliding the memory card to a side where the battery positioning portion is disposed.

2. The operation panel for a power conversion device according to Claim 1, wherein
the operation panel main body is detachably attached to the power conversion device main body portion.

3. The operation panel for a power conversion device according to Claim 1 or 2, further comprising:
wherein
the operation panel board is provided with a stroke area (S) for sliding the memory card to insert the card into the card slot portion and remove the card from the card slot portion, and
the opening portion is provided in the rear cover such that the battery positioning portion and the stroke area are exposed.

4. The operation panel for a power conversion device according to Claim 3, wherein
the stroke area is provided between the card slot portion and the battery positioning portion.

5. The operation panel for a power conversion device according to Claim 3 or 4, wherein
the battery positioning portion is configured to be flexurally deformable at the time of the attachment and detachment of the button battery, and
the rear cover further includes a flexure regulating portion (22) that regulates a flexural deformation amount of the battery positioning portion at the time of the attachment and detachment of the button battery.

6. The operation panel for a power conversion device according to Claim 4 or 5, wherein
the battery positioning portion includes a snap-fit portion (21) that is provided along an outer peripheral surface (P) of the button battery and is flexurally deformable at the time of the attachment and detachment of the button battery, and
the snap-fit portion is provided with a positioning projection portion (21c) that projects on a side where the button battery is disposed and on a side where the second terminal is disposed, in order to position a position of the button battery with respect to the second terminal.

7. The operation panel for a power conversion device according to Claim 6, wherein
the snap-fit portion includes a pair of arm portions having an arc shape (21a), which are elastically deformable, provided in an arc shape along the outer peripheral surface of the button battery, and
tip ends of the pair of arm portions having the arc shape are provided on a side where the stroke area is disposed with respect to the button battery.

8. The operation panel for a power conversion device according to Claim 7, wherein
the first terminal is disposed on a tip end side of the pair of arm portions having the arc shape from a central portion of the position where the button battery is disposed, in an area surrounded by the pair of arm portions having the arc shape.

9. The operation panel for a power conversion device according to any one of Claims 6 to 8, wherein
the second terminal is disposed on an outer peripheral surface side of the button battery and is configured to be flexurally deformable, and
the rear cover further includes a position regulating portion (23) that regulates a position of the outer peripheral surface of the button battery with respect to the second terminal in order to regulate a flexural deformation amount of the second terminal.

10. The operation panel for a power conversion device according to any one of Claims 6 to 9, wherein
a plurality of the second terminals are provided along the outer peripheral surface of the button battery.

11. The operation panel for a power conversion device according to any one of Claims 3 to 10, wherein
the rear cover further includes an intrusion prevention portion (24) that prevents the memory card from intruding between the rear cover and the operation panel board, which is provided along an outer edge of the stroke area so as to project toward the operation panel board side.

12. The operation panel for a power conversion device according to any one of Claims 1 to 11, wherein
the battery cover includes a projection portion (31) that projects toward a first terminal side provided on the operation panel board in a state of being attached to the rear cover to press the button battery toward the first terminal side.

13. The operation panel for a power conversion device according to any one of Claims 1 to 12, wherein
the power conversion device main body portion is accommodated and a rear side of an operation panel main body is configured to be attached to a control panel that performs power control, and
the operation panel further comprises a sealing member (40), between the rear cover and the control panel, provided on an outside of the battery cover so as to surround the battery cover.

14. The operation panel for a power conversion device according to Claim 13, wherein
the battery cover is disposed at a central portion of a surface of the rear cover facing the control panel, and
the rear cover has a groove portion (25) which is formed along an outer peripheral portion of the surface of the rear cover facing the control panel and into which the sealing member is fitted.

15. A power conversion device (100) comprising:
a power conversion device main body portion (102); and
an operation panel (101) according to one of the preceeding claims that is detachably attached to the power conversion device main body portion.

## Patentansprüche

1. Bedienfeld (101) für eine Stromumwandlungsvorrichtung (100), umfassend:
eine Bedienfeldplatte (50), die an einer Vorderseite mit Bedieneinheiten (2, 4) versehen ist und die einen Stromumwandlungsvorrichtungshauptkörperabschnitt (102) bedienen;
einen ersten Anschluss (51) und einen zweiten Anschluss (52), die entsprechend einer Knopfbatterie (B) zum Versorgen der Bedienfeldplatte mit Strom auf einer Rückfläche der Bedienfeldplatte vorgesehen sind;
eine hintere Abdeckung (20), die einen Batteriepositionierungsabschnitt (21) umfasst, der konfiguriert ist, die Knopfbatterie in Bezug auf den ersten Anschluss und den zweiten Anschluss zu positionieren, und einen Öffnungsabschnitt (A1), der derart vorgesehen ist, dass der Batteriepositionierungsabschnitt freigelegt ist, der derart angeordnet ist, dass er die Rückfläche der Bedienfeldplatte abdeckt;
eine Batterieabdeckung (30), die konfiguriert ist, an der hinteren Abdeckung angebracht und davon abgenommen zu werden, und derart vorgesehen ist, dass sie den Öffnungsabschnitt abdeckt, und
einen Kartensteckplatzabschnitt (53) zum Einstecken einer Speicherkarte (C), der auf der Rückfläche der Bedienfeldplatte vorgesehen ist,
wobei das Bedienfeld derart aufgebaut ist, dass die Speicherkarte (C) aus dem Kartensteckplatzabschnitt (53) entfernt werden kann, indem die Speicherkarte zu einer Seite geschoben wird, an welcher der Batteriepositionierungsabschnitt angeordnet ist.

2. Bedienfeld für eine Stromumwandlungsvorrichtung nach Anspruch 1, wobei
der Bedienfeldhauptkörper an dem Stromumwandlungsvorrichtungshauptkörperabschnitt abnehmbar angebracht ist.

3. Bedienfeld für eine Stromumwandlungsvorrichtung nach Anspruch 1 oder 2, ferner umfassend:
wobei
die Bedienfeldplatte mit einem Streichbereich (S) zum Schieben der Speicherkarte, um die Karte in den Kartensteckplatzabschnitt einzustecken und die Karte aus dem Kartensteckplatzabschnitt zu entfernen, versehen ist und
der Öffnungsabschnitt in der hinteren Abdeckung vorgesehen ist, sodass der Batteriepositionierungsabschnitt und der Streichbereich freigelegt sind.

4. Bedienfeld für eine Stromumwandlungsvorrichtung nach Anspruch 3, wobei
der Streichbereich zwischen dem Kartensteckplatzabschnitt und dem Batteriepositionierungsabschnitt vorgesehen ist.

5. Bedienfeld für eine Stromumwandlungsvorrichtung nach Anspruch 3 oder 4, wobei
der Batteriepositionierungsabschnitt konfiguriert ist, zum Zeitpunkt des Anbringens und Abnehmens der Knopfbatterie biegsam verformbar zu sein, und
die hintere Abdeckung ferner einen Biegungsregulierungsabschnitt (22) umfasst, der einen Biegeverformungsbetrag des Batteriepositionierungsabschnitts zum Zeitpunkt des Anbringens und Abnehmens der Knopfbatterie reguliert.

6. Bedienfeld für eine Stromumwandlungsvorrichtung nach Anspruch 4 oder 5, wobei
der Batteriepositionierungsabschnitt einen Schnappverschlussabschnitt (21) umfasst, der entlang einer Außenumfangsfläche (P) der Knopfbatterie vorgesehen ist und zum Zeitpunkt des Anbringens und Abnehmens der Knopfbatterie biegsam verformbar ist, und
der Schnappverschlussabschnitt mit einem Positionierungsvorsprungabschnitt (21c) versehen ist, der auf einer Seite, an der die Knopfbatterie angeordnet ist, und auf einer Seite, an welcher der zweite Anschluss angeordnet ist, vorsteht, um eine Position der Knopfbatterie in Bezug auf den zweiten Anschluss zu positionieren.

7. Bedienfeld für eine Stromumwandlungsvorrichtung nach Anspruch 6, wobei
der Schnappverschlussabschnitt ein Paar von Armabschnitten mit einer Bogenform (21a) umfasst, die elastisch verformbar sind und entlang der Außenumfangsfläche der Knopfbatterie in einer Bogenform vorgesehen sind, und
Spitzenenden des Paars von Armabschnitten mit der Bogenform auf einer Seite vorgesehen sind, wo der Streichbereich in Bezug auf die Knopfbatterie angeordnet ist.

8. Bedienfeld für eine Stromumwandlungsvorrichtung nach Anspruch 7, wobei
der erste Anschluss an einer Spitzenendseite des Paars von Armabschnitten mit der Bogenform von einem Mittelabschnitt der Position, an der die Knopfbatterie angeordnet ist, in einem Bereich angeordnet ist, der von dem Paar von Armabschnitten mit der Bogenform umgeben ist.

9. Bedienfeld für eine Stromumwandlungsvorrichtung nach einem der Ansprüche 6 bis 8, wobei
der zweite Anschluss an einer Außenumfangsflächenseite der Knopfbatterie angeordnet und konfiguriert ist, biegsam verformbar zu sein, und
die hintere Abdeckung ferner einen Positionsregulierungsabschnitt (23) umfasst, der eine Position der Außenumfangsfläche der Knopfbatterie in Bezug auf den zweiten Anschluss reguliert, um einen Biegeverformungsbetrag des zweiten Anschlusses zu regulieren.

10. Bedienfeld für eine Stromumwandlungsvorrichtung nach einem der Ansprüche 6 bis 9, wobei
mehrere der zweiten Anschlüsse entlang der Außenumfangsfläche der Knopfbatterie vorgesehen sind.

11. Bedienfeld für eine Stromumwandlungsvorrichtung nach einem der Ansprüche 3 bis 10, wobei
die hintere Abdeckung ferner einen Eindringungsverhinderungsabschnitt (24) umfasst, der verhindert, dass die Speicherkarte zwischen der hinteren Abdeckung und der Bedienfeldplatte eindringt, und der entlang einer Außenkante des Streichbereichs vorgesehen ist, sodass er in Richtung der Bedienfeldplattenseite vorsteht.

12. Bedienfeld für eine Stromumwandlungsvorrichtung nach einem der Ansprüche 1 bis 11, wobei
die Batterieabdeckung einen Vorsprungsabschnitt (31) umfasst, der in Richtung einer an der Bedienfeldplatte vorgesehenen ersten Anschlussseite in einem Zustand, in dem er an der hinteren Abdeckung angebracht ist, um die Knopfbatterie in Richtung der ersten Anschlussseite zu drücken, vorsteht.

13. Bedienfeld für eine Stromumwandlungsvorrichtung nach einem der Ansprüche 1 bis 12, wobei
der Stromumwandlungsvorrichtungshauptkörperabschnitt in einem Steuerpult, das eine Stromsteuerung ausführt, untergebracht ist und eine Rückseite eines Bedienfeldhauptkörpers konfiguriert ist, daran angebracht zu werden, und
das Bedienfeld ferner ein Dichtungselement (40) zwischen der hinteren Abdeckung und dem Steuerpult umfasst, das an einer Außenseite der Batterieabdeckung vorgesehen ist, sodass es die Batterieabdeckung umgibt.

14. Bedienfeld für eine Stromumwandlungsvorrichtung nach Anspruch 13, wobei
die Batterieabdeckung an einem Mittelabschnitt einer Fläche der hinteren Abdeckung angeordnet ist, die dem Steuerpult zugewandt ist, und
die hintere Abdeckung einen Nutabschnitt (25) aufweist, der entlang eines Außenumfangsabschnitts der Fläche der hinteren Abdeckung gebildet ist, die dem Steuerpult zugewandt ist, und in den das Dichtungselement eingepasst ist.

15. Stromumwandlungsvorrichtung (100), umfassend:
einen Stromumwandlungsvorrichtungshauptkörperabschnitt (102); und
ein Bedienfeld (101) nach einem der vorstehenden Ansprüche, das an dem Stromumwandlungsvorrichtungshauptkörperabschnitt abnehmbar angebracht ist.

## Revendications

1. Panneau de commande (101) pour un dispositif de conversion de puissance (100) comprenant :
un tableau de commande (50) prévu avec des unités de commande (2, 4) qui commandent une partie de corps principal (102) du dispositif de conversion de puissance sur un côté avant ;
une première borne (51) et une seconde borne (52) prévues en correspondance d'une pile bouton (B) pour alimenter le tableau de commande sur une surface arrière du tableau de commande ;
un couvercle arrière (20) comprenant une partie de positionnement de pile (21) configurée pour positionner la pile bouton par rapport à la première borne et à la seconde borne et une partie d'ouverture (A1) prévue de sorte que la partie de positionnement de pile qui est exposée, est disposée afin de recouvrir la surface arrière du tableau de commande ;
un couvercle de pile (30) qui est configuré pour être fixé sur et détaché du couvercle arrière et prévu afin de recouvrir la partie d'ouverture, et
une partie de fente pour carte (53) pour insérer une carte mémoire (C), qui est prévue sur la surface arrière du tableau de commande,
dans lequel le panneau de commande est structuré de sorte que la carte mémoire (C) peut être retirée de la partie de fente pour carte (53) en faisant glisser la carte mémoire vers un côté où la partie de positionnement de pile est disposée.

2. Panneau de commande pour un dispositif de conversion de puissance selon la revendication 1, dans lequel :
le corps principal de panneau de commande est fixé de manière détachable sur la partie de corps principal du dispositif de conversion de puissance.

3. Panneau de commande pour un dispositif de conversion de puissance selon la revendication 1 ou 2, comprenant en outre :
dans lequel :
le tableau de commande est prévu avec une zone de course (S) pour faire glisser la carte mémoire afin d'insérer la carte dans la partie de fente pour carte et retirer la carte de la partie de fente pour carte, et
la partie d'ouverture est prévue dans le couvercle arrière de sorte que la partie de positionnement de pile et la zone de course sont exposées.

4. Panneau de commande pour un dispositif de conversion de puissance selon la revendication 3, dans lequel :
la zone de course est prévue entre la partie de fente pour carte et la partie de positionnement de pile.

5. Panneau de commande pour un dispositif de conversion de puissance selon la revendication 3 ou 4, dans lequel :
la partie de positionnement de pile est configurée pour être déformable en flexion au moment de la fixation et du détachement de la pile bouton, et
le couvercle arrière comprend en outre une partie de régulation de flexion (22) qui régule une quantité de déformation en flexion de la partie de positionnement de pile au moment de la fixation et du détachement de la pile bouton.

6. Panneau de commande pour un dispositif de conversion de puissance selon la revendication 4 ou 5, dans lequel :
la partie de positionnement de pile comprend une partie d'encliquetage (21) qui est prévue le long d'une surface périphérique externe (P) de la pile bouton et est déformable en flexion au moment de la fixation et du détachement de la pile bouton, et
la partie d'encliquetage est prévue avec une partie de saillie de positionnement (21c) qui fait saillie sur un côté où la pile bouton est disposée et sur un côté où la seconde borne est disposée, afin de positionner une position de la pile bouton par rapport à la seconde borne.

7. Panneau de commande pour un dispositif de conversion de puissance selon la revendication 6, dans lequel :
la partie d'encliquetage comprend une paire de parties de bras ayant une forme d'arc (21a), qui sont élastiquement déformables, prévues dans une forme d'arc le long de la surface périphérique externe de la pile bouton, et
les extrémités de pointe de la paire de parties de bras ayant la forme d'arc sont prévues sur un côté où la zone de course est disposée par rapport à la pile bouton.

8. Panneau de commande pour un dispositif de conversion de puissance selon la revendication 7, dans lequel :
la première borne est disposée sur un côté d'extrémité de pointe de la paire de parties de bras ayant la forme d'arc par rapport à la partie centrale de la position où la pile bouton est disposée, dans une zone entourée par la paire de parties de bras ayant la forme d'arc.

9. Panneau de commande pour un dispositif de conversion de puissance selon l'une quelconque des revendications 6 à 8, dans lequel :
la seconde borne est disposée sur un côté de surface périphérique externe de la pile bouton et est configurée pour être déformable en flexion, et
le couvercle arrière comprend en outre une partie de régulation de position (23) qui régule une position de la surface périphérique externe de la pile bouton par rapport à la seconde borne afin de réguler une quantité de déformation en flexion de la seconde borne.

10. Panneau de commande pour un dispositif de conversion de puissance selon l'une quelconque des revendications 6 à 9, dans lequel :
une pluralité de secondes bornes sont prévues le long de la surface périphérique externe de la pile bouton.

11. Panneau de commande pour un dispositif de conversion de puissance selon l'une quelconque des revendications 3 à 10, dans lequel :
le couvercle arrière comprend en outre une partie de prévention d'intrusion (24) qui empêche la carte mémoire de pénétrer entre le couvercle arrière et le tableau de commande, qui est prévu le long d'un bord externe de la zone de course afin de faire saillie du côté du tableau de commande.

12. Panneau de commande pour un dispositif de conversion de puissance selon l'une quelconque des revendications 1 à 11, dans lequel :
le couvercle de pile comprend une partie de saillie (31) qui fait saillie du côté de la première borne prévue sur le tableau de commande dans un état dans lequel elle est fixée au couvercle arrière afin d'appuyer la pile bouton vers le côté de la première borne.

13. Panneau de commande pour un dispositif de conversion de puissance selon l'une quelconque des revendications 1 à 12, dans lequel :
la partie de corps principal du dispositif de conversion de puissance est logée et un côté arrière d'un corps principal de panneau de commande est configuré pour être fixé à un panneau de contrôle qui réalise la contrôle de puissance, et
le panneau de commande comprend en outre un élément d'étanchéité (40) entre le couvercle arrière et le panneau de contrôle, prévu à l'extérieur du couvercle de pile afin d'entourer le couvercle de pile.

14. Panneau de commande pour un dispositif de conversion de puissance selon la revendication 13, dans lequel :
le couvercle de pile est disposé au niveau d'une partie centrale d'une surface du couvercle arrière faisant face au panneau de contrôle, et
le couvercle arrière a une partie de rainure (25) qui est formée le long d'une partie périphérique externe de la surface du couvercle arrière faisant face au panneau de contrôle et dans lequel l'élément d'étanchéité est monté.

15. Dispositif de conversion de puissance (100) comprenant :
une partie de corps principal (102) du dispositif de conversion de puissance ; et
un panneau de commande (101) selon l'une des revendications précédentes qui est fixé, de manière détachable, à la partie de corps principal du dispositif de conversion de puissance.
